(19) Europäisches Patentamt
European Patent Office
Office européen des brevets

(11) **EP 2 219 203 B1**

(12) **FASCICULE DE BREVET EUROPEEN**

(45) Date de publication et mention
de la délivrance du brevet:
**19.03.2014 Bulletin 2014/12**

(51) Int Cl.:
***H01J 37/153*** (2006.01)   ***H01J 37/26*** (2006.01)

(21) Numéro de dépôt: **10152926.1**

(22) Date de dépôt: **08.02.2010**

(54) **Procédé de correction d'astigmatisme en imagerie par spectromicroscopie à émission d'électrons**

Verfahren zur Korrektur von Astigmatismus bei Bildgebungsverfahren durch Spektromikroskopie mit Elektronenemission

Method for correcting astigmatism using electron-emitting spectromicroscopic imaging

(84) Etats contractants désignés:
**AT BE BG CH CY CZ DE DK EE ES FI FR GB GR HR HU IE IS IT LI LT LU LV MC MK MT NL NO PL PT RO SE SI SK SM TR**

(30) Priorité: **11.02.2009 FR 0950841**

(43) Date de publication de la demande:
**18.08.2010 Bulletin 2010/33**

(73) Titulaire: **Commissariat à l'Énergie Atomique et aux Énergies Alternatives**
**75015 Paris (FR)**

(72) Inventeurs:
• **Renault, Olivier**
**38660 Saint Pancrasse (FR)**
• **Lavayssière, Maylis**
**38000 Grenoble (FR)**
• **Mariolle, Denis**
**38100 Grenoble (FR)**

(74) Mandataire: **Ilgart, Jean-Christophe**
**BREVALEX**
**95 rue d'Amsterdam**
**75378 Paris Cedex 8 (FR)**

(56) Documents cités:
JP-A- 2004 265 652     US-A1- 2004 004 773
US-A1- 2004 114 132

**Description**

**DOMAINE TECHNIQUE**

L'invention concerne le domaine de l'imagerie par spectromicroscopie, et plus particulièrement celui de la correction des défauts, notamment de l'astigmatisme, d'une colonne optique électronique d'un spectromicroscope à émission d'électrons, par exemple à émission d'électrons photo-excités ou photoélectrons. L'invention s'applique particulièrement dans le domaine de l'imagerie XPS plein champ (spectromicroscopie à photoélectrons par rayons X).

**ÉTAT DE LA TECHNIQUE ANTÉRIEURE**

La spectromicroscopie, qui combine la spectroscopie d'électrons et la microscopie, est une technique d'imagerie consistant à irradier une grande surface d'un échantillon à imager par un large faisceau présentant une certaine énergie. Lorsque ce faisceau est un faisceau de rayons X, on parle d'imagerie XPS. Cette technique utilise le principe de l'effet photoélectrique concernant certains des électrons des atomes du matériau de l'échantillon à imager. Lorsqu'un photon interagit avec un électron d'une des couches électroniques d'un atome du matériau de l'échantillon, ce photon lui cède son énergie initiale. Une partie de cette énergie permet à l'électron d'effectuer une transition depuis son orbitale initiale vers le niveau du vide. Cette énergie correspond à l'énergie de liaison de l'électron. L'énergie résiduelle est transmise à l'électron sous forme d'énergie cinétique. En mesurant cette énergie cinétique par l'intermédiaire d'un analyseur en énergie, également appelé filtre en énergie, et en connaissant l'énergie du rayonnement incident, il est possible d'en déduire l'énergie de liaison de l'électron éjecté et donc de caractériser la nature de l'échantillon en termes d'éléments chimiques.

On réalise une spectromicroscopie plein champ à l'aide d'une colonne optique électronique et d'un analyseur en énergie. La colonne collecte et image la totalité des électrons éjectés de la surface de l'échantillon par effet photoélectrique. La collection des photoélectrons par la colonne est réalisée grâce à un fort champ électrique généré entre l'échantillon et l'objectif de la colonne, appelé champ électrique d'extraction. L'analyseur en énergie, par exemple de type hémisphérique, réalise un filtrage en énergie de l'image produite par la colonne en sélectionnant sur un très faible intervalle d'énergie les électrons transmis par la colonne.

Il existe divers facteurs limitant la résolution latérale (résolution de l'image dans le plan de l'échantillon) en imagerie par émission d'électrons, par exemple en PEEM.

Tout d'abord, la topographie physique de l'échantillon joue un rôle important dans la qualité de l'image obtenue. En effet, si la surface de l'échantillon est rugueuse, ces irrégularités vont perturber le champ électrique d'extraction généré entre l'échantillon et l'objectif, ce qui a pour effet de dévier la trajectoire des photoélectrons émis, entraînant des sur-intensités et des sous-intensités dans l'image obtenue. Les échantillons doivent donc présenter une surface la plus plane possible afin de réduire ces défauts dus aux topographies de l'échantillon.

Les aberrations sphériques et chromatiques, dues à la fois au champ électrique d'extraction et aux lentilles électrostatiques de l'objectif elles-mêmes, sont également des défauts limitant la résolution en imagerie par émission d'électrons. Les aberrations sphériques ont pour effet que pour une même énergie cinétique, les photoélectrons qui présentent un angle élevé avec l'axe optique ne se focalisent pas dans le plan focal. L'utilisation d'un diaphragme permet de limiter l'angle maximal de collection des photoélectrons, mais en contre partie réduit l'intensité transmise par la colonne. Les aberrations chromatiques proviennent quant à elles du fait que des photoélectrons ayant un angle similaire par rapport à l'axe optique peuvent avoir des énergies cinétiques différentes et ne vont alors pas se focaliser dans le même plan.

Il est connu de corriger ces aberrations sphériques et chromatiques en faisant appel à différents instruments : miroirs électroniques, hexapôle, etc.

L'astigmatisme est également un facteur limitant la résolution latérale en imagerie PEEM. En effet, la colonne PEEM n'a pas un axe optique parfait, ces imperfections étant généralement des désalignements entre les lentilles ou bien des champs magnétiques résiduels. Les lentilles elles-mêmes ne sont pas non plus parfaites, et souvent leur transmission autour de l'axe optique n'est pas symétrique. La distance focale autour de l'axe optique peut ainsi varier selon la direction d'observation. Les trajectoires électroniques ne se focalisent pas de la même façon dans un plan parallèle à l'axe optique et un plan perpendiculaire à l'axe optique : les composantes verticales se focalisent à une distance plus courte dans un plan appelé plan tangentiel, et les composantes horizontales se focalisent à une distance plus grande, dans un plan appelé plan sagittal. Ainsi, les images vont sembler déformées. Par exemple, un carré va apparaître rectangulaire et un cercle va apparaître ellipsoïdal lorsqu'on est situé autour du point focal image. Cet astigmatisme se traduit par une diminution de la qualité des images obtenues (diminution de la résolution latérale, du contraste, ...), et la bonne tension de focalisation qui doit être appliquée est difficile à trouver.

Le document US 7 126 120 B2 décrit un procédé de correction de l'astigmatisme d'une colonne optique électronique, par exemple d'un spectromicroscope, dans lequel une évaluation de l'astigmatisme de la colonne puis une correction de cet astigmatisme sont réalisées en jouant par itérations sur les courants de commande d'un déflecteur/stigmateur de la colonne, qui peut être un octopôle électrostatique permettant de corriger l'astigmatisme dans toutes les directions.

Un autre procédé de correction d'astigmatisme d'une colonne optique électronique d'un spectromicroscope à émission d'électrons est décrit dans le document JP 2004 265 652.

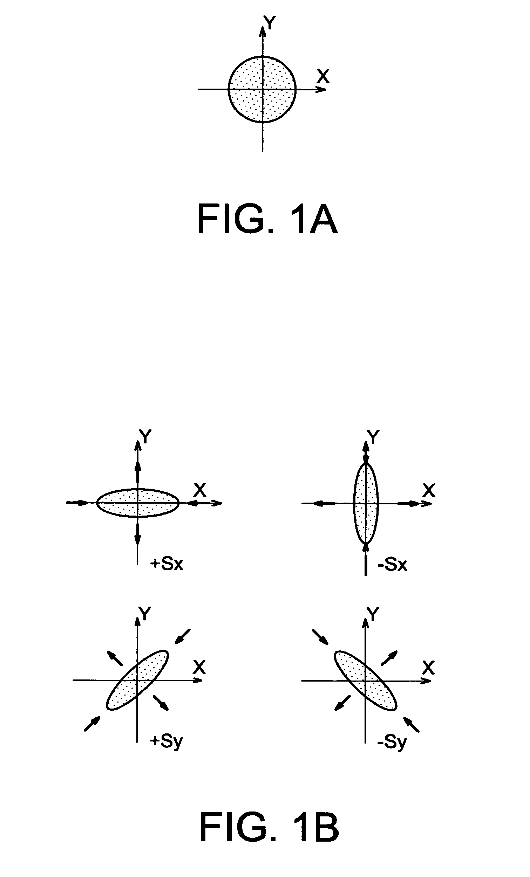

La figure 1A représente un motif circulaire imagé sans astigmatisme dans l'optique d'un microscope. Par opposition, la figure 1B représente ce même motif imagé avec des déformations dues à un astigmatisme prononcé dans différentes directions. On voit sur cette figure 1B que l'astigmatisme peut se traduire par des déformations selon des directions parallèles et perpendiculaires par rapport à l'axe X (0° et 90° par rapport à l'axe X), qui peuvent être corrigées en jouant sur la tension de commande de l'axe Sx du stigmateur de la colonne, et des déformations selon des directions à 45° et 135° par rapport à l'axe X, qui peuvent être corrigées en jouant sur la tension de commande de l'axe Sy du stigmateur de la colonne.

Un tel procédé a toutefois pour inconvénient majeur de ne pas pouvoir s'appliquer en pratique pour de nombreux échantillons car les structures d'intérêts de ces échantillons que l'on cherche à imager possèdent généralement un motif ne permettant pas de bien mettre en valeur les défauts d'astigmatisme de la colonne. Par exemple, dans le cas d'un échantillon dont la structure d'intérêt que l'on cherche à imager est composée de bandes horizontales, il sera impossible d'évaluer et de corriger l'astigmatisme dans cette direction horizontale parallèle à l'orientation des bandes de la structure d'intérêt de l'échantillon.

**EXPOSÉ DE L'INVENTION**

Un but de la présente invention est d'optimiser les conditions d'observation durant un procédé d'imagerie par spectromicroscopie à émission d'électrons, par exemple à photoélectrons, d'une structure d'intérêt d'un échantillon en corrigeant les défauts de la colonne optique électronique d'un spectromicroscope, et notamment l'astigmatisme.

Pour cela, la présente invention propose un procédé de correction d'astigmatisme d'une colonne optique électronique d'un spectromicroscope à émission d'électrons, comportant au moins les étapes de :

- réalisation d'une structure de référence sur une surface d'un échantillon comportant une structure d'intérêt à imager, les dimensions du contour extérieur de la structure de référence, selon deux axes perpendiculaires l'un par rapport à l'autre et appartenant à un plan parallèle à la surface de l'échantillon, étant sensiblement similaires,
- imagerie de la structure de référence par le spectromicroscope en électrons secondaires et en photoélectrons de niveaux de coeur,
- suppression des défauts d'astigmatisme apparaissant lors de l'imagerie de la structure de référence en électrons secondaires et en photoélectrons des niveaux de coeur,

le matériau de la structure de référence étant choisi tel que, lors d'une observation en photoélectrons de niveaux de coeur, le contraste C entre l'intensité moyenne $I_a$ du matériau de la structure de référence et l'intensité moyenne $I_b$ du matériau de l'échantillon soit tel que :

$$C = \frac{I_a - I_b}{I_a + I_b} \geq 0,2 \ .$$

On entend par « intensité moyenne », ici et dans tout le reste du document, la valeur moyenne de l'intensité lumineuse des pixels dans l'image pour une zone donnée.

La suppression des défauts d'astigmatisme peut être réalisée par un ajustement d'une tension de réglages d'un stigmateur du spectromicroscope, puis un ajustement d'une tension de focalisation du spectromicroscope.

On réalise donc, à la surface de l'échantillon à étudier, une structure de référence qui pourra être imagée en électrons secondaires ou en photoélectrons de niveaux de coeur. Grâce à l'utilisation de la structure de référence, qui est réalisée sur l'échantillon comprenant la structure d'intérêt que l'on cherche à imager, il est possible de corriger l'astigmatisme de la colonne du spectromicroscope quelque soit la géométrie (forme, dimensions, ...) de la structure d'intérêt à imager, et notamment lorsque la structure d'intérêt comporte des éléments s'étendant longitudinalement, par exemple des bandes, qui ne peuvent être utilisées seules pour corriger l'astigmatisme de la colonne du spectromicroscope. On peut ainsi réaliser une imagerie, par exemple de type XPS, à haute résolution latérale de la structure d'intérêt.

La structure de référence peut donc comporter une unique portion de matériau, par exemple en forme de disque ou d'une autre forme géométrique.

La structure de référence peut comporter une pluralité de portions du matériau de la structure de référence formant des motifs concentriques de tailles différentes et distants les uns des autres d'une distance non nulle.

Ainsi, en utilisant les différents motifs de la structure de référence, il est possible de corriger des défauts d'astigmatisme apparaissant sur des champs de vue de différentes tailles : grands, c'est-à-dire par exemple entre environ 600 $\mu$m et 100 $\mu$m ; moyens, c'est-à-dire par exemple entre environ 100 $\mu$m et 25 $\mu$m ; ou petits, c'est à dire par exemple inférieur à environ 25 $\mu$m. L'utilisateur n'a donc qu'à régler le grossissement du spectromicroscope pour observer ces différents motifs et corriger les défauts d'astigmatisme pour les champs de vue qui l'intéressent.

Les contours extérieurs des portions de matériau de la structure de référence peuvent être homothétiques les uns par rapport aux autres et/ou s'étendre à 360° autour du centre de la structure de référence. Ainsi, la structure de référence peut comporter plusieurs motifs géométriques (carrés, disques, ...) imbriqués les uns dans les autres, facilitant pour l'utilisateur une appréciation visuelle (qualitative) de la présence d'astigmatisme.

Les motifs des portions de matériau de la structure de référence peuvent comporter des motifs géométriques disposés les uns dans les autres, ou comporter un motif de grille ou de spirale (une grille et une spirale pouvant être décomposées en plusieurs motifs concentriques et distants les uns des autres d'une distance non nulle).

Par exemple, les motifs des portions de matériau de la structure de référence peuvent comporter des anneaux.

Les motifs des portions de matériau de la structure de référence peuvent comporter des largeurs (dimensions des portions de matériau dans le plan du substrat) différentes.

Les dimensions du contour extérieur de la structure de référence peuvent être choisies en fonction du champ de vue du spectromicroscope utilisé pour la correction d'astigmatisme et peuvent être, par exemple, au moins égales à environ 1/25ème de la taille du champ de vue du spectromicroscope. Par exemple, pour des champs de vue inférieurs à environ 127 $\mu$m, les dimensions du contour extérieur de la structure de référence peuvent être comprises entre environ 2 $\mu$m et 10 $\mu$m. Pour un champ de vue compris entre environ 20 $\mu$m et 127 $\mu$m, ces dimensions peuvent être comprises entre environ 5 $\mu$m et 10 $\mu$m, par exemple égales à environ 10 $\mu$m. Pour un champ de vue inférieur à environ 20 $\mu$m, par exemple égal à environ 18 $\mu$m, ces dimensions peuvent comprises entre environ 2 $\mu$m et 5 $\mu$m, et par exemple égales à environ 5 $\mu$m. En choisissant de réaliser une structure de référence de dimensions suffisantes, par exemple au moins égales à environ 1/25ème de la taille du champ de vue du spectromicroscope, on facilite la correction de l'astigmatisme en se réservant la possibilité de travailler avec une bonne statistique de comptage au champ de vue typique utilisé par le spectromicroscope avec les photoélectrons de niveaux de coeur, notamment lorsque le spectromicroscope est paramétré en grand champ de vue (fenêtre d'observation égale à environ 200 $\mu$m par exemple) et en imagerie des photoélectrons de niveaux de coeur.

De plus, lorsque l'on souhaite corriger l'astigmatisme sur les niveaux de coeur, étant donné que la probabilité d'excitation des photoélectrons de niveaux de coeur est plus faible que celle des électrons secondaires, de telles dimensions permettent de former une structure de référence assez large pouvant être facilement imagée. Ainsi, on peut utiliser le spectromicroscope en photoélectrons de niveaux de coeur avec une source d'excitation de brillance limitée en choisissant d'une part un champ de vue suffisamment grand pour permettre une statistique de comptage suffisante, et d'autre part une structure de référence présentant une surface assez importante, par exemple supérieure à environ 1/25ème de la taille du champ de vue, ce qui permet de réduire le temps d'acquisition de l'image, et permet ainsi de réaliser l'acquisition d'un plus grand nombre d'images pour affiner le réglage de l'astigmatisme.

Dans le cas d'un instrument d'imagerie par exemple du type XPS, sa résolution spatiale varie en fonction de l'énergie du rayonnement utilisé. La distance entre les portions de matériau de la structure de référence et/ou la largeur (dimension selon l'un des deux axes perpendiculaires l'un par rapport à l'autre et appartenant au plan parallèle à la surface de l'échantillon) des portions de matériau de la structure de référence peuvent être supérieures ou égales à environ deux fois, ou comprises entre environ 1,5 fois et 2,5 fois, la meilleure résolution spatiale du spectromicroscope lors d'une observation de la structure d'intérêt.

Afin d'obtenir un contraste supérieur ou égal à environ 0,2, il convient de réaliser la structure de référence dans un matériau adapté par rapport au matériau de l'échantillon sur lequel est réalisée la structure de référence. Pour cela, le matériau de la structure de référence peut être choisi tel que sa composition élémentaire diffère fortement de celle du matériau de l'échantillon.

Ainsi, la différence entre le travail de sortie du matériau de la structure de référence et le travail de sortie du matériau de l'échantillon peut être supérieure ou égale à environ 0,2 eV et/ou, lorsque les matériaux de la structure de référence et de l'échantillon sont à base d'au moins un même élément, la concentration de cet élément dans le matériau de la structure de référence peut être différente de la concentration de cet élément dans le matériau de l'échantillon et/ou, lorsque les matériaux de la structure de référence et de l'échantillon sont de même nature, ces matériaux peuvent être dopés différemment.

De manière avantageuse, il est possible de choisir le matériau de la structure de référence tel qu'un photoélectron de niveau de coeur d'au moins un élément constitutif de celui-ci présente une section efficace élevée en fonction de l'énergie du faisceau d'excitation utilisé lors de l'observation de l'échantillon. Le matériau de la structure de référence peut être choisi tel que la section efficace d'un photoélectron de niveau de coeur d'au moins un élément constitutif du matériau de la structure de référence soit supérieure ou égale à environ 0,1 Mbarn (1 Mbarn = $10^{-22}$ m$^2$). En choisissant un matériau présentent une telle section efficace, on garantit une bonne probabilité de photoexcitation des électrons de niveaux de coeur du matériau de la structure de référence.

Le matériau de la structure de référence peut être tel que l'énergie cinétique des photoélectrons de niveaux de coeur utilisés pour l'imagerie d'au moins un des éléments constitutifs de ce matériau soit inférieure ou égale à environ quelques centaines d'eV, ou inférieure à environ 1000 eV. Ainsi, en choisissant un matériau dont les photoélectrons à imager peuvent être excités de telle façon que leur énergie cinétique soit faible (l'énergie cinétique dépendant de l'énergie du faisceau d'excitation), on améliore leur transmission par le spectromicroscope, améliorant le contraste obtenu entre le matériau de la structure de référence et le matériau de l'échantillon.

Le matériau de la structure de référence peut être électriquement conducteur ou semi-conducteur. En faisant appel à des dispositifs à compensation de charges, le matériau de la structure de référence peut être un diélectrique.

La réalisation de la structure de référence peut comporter au moins une étape de dépôt localisé du matériau de la structure de référence sur l'échantillon à une distance supérieure à environ 100 $\mu$m de la structure d'intérêt afin d'éviter une détérioration éventuelle de la structure d'intérêt, et une étape d'usinage du matériau déposé, formant la structure de référence.

Dans ce cas, le matériau de la structure de référence peut être déposé sur une épaisseur sensiblement homogène comprise entre environ 15 nm et 200 nm, et avantageusement inférieure à environ 30 nm et/ou l'usinage peut être réalisé sur une profondeur supérieure d'environ 1 nm ou 2 nm à l'épaisseur du matériau déposé.

Le procédé de correction d'astigmatisme peut comporter en outre, avant la mise en oeuvre d'une étape d'imagerie de la structure de référence par le spectromicroscope en photoélectrons de niveaux de coeur puis d'une étape de suppression de défauts d'astigmatisme apparaissant lors de l'imagerie de la structure de référence en photoélectrons de niveaux de coeur, une étape d'imagerie de la structure de référence par le spectromicroscope en électrons secondaires, puis une étape de suppression de défauts d'astigmatisme apparaissant lors de l'imagerie de la structure de référence en électrons secondaires.

Une suppression de défauts d'astigmatisme apparaissant lors de l'imagerie de la structure de référence en électrons secondaires ou en photoélectrons de niveaux de coeur peut être réalisée par un ajustement des tensions de réglage d'un stigmateur de la colonne puis par un ajustement de la tension de focalisation du spectromicroscope.

L'invention concerne également un procédé d'imagerie par spectromicroscopie à émission d'électrons, comportant la mise en oeuvre d'un procédé de correction d'astigmatisme tel que décrit ci-dessus, et une ou plusieurs étapes d'imagerie de la structure d'intérêt en électrons secondaires et/ou en photoélectrons de niveaux de coeur.

## BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :

- la figure 1A représente schématiquement un motif circulaire imagé sans astigmatisme dans l'optique d'un microscope, et la figure 1B représente schématiquement ce même motif imagé avec des déformations dues à un astigmatisme prononcé dans différentes directions,
- la figure 2 représente un exemple de colonne optique électronique d'un spectromicroscope à émission d'électrons, par exemple à photoélectrons, utilisé dans un procédé d'imagerie, objet de la présente invention,
- la figure 3 représente un exemple d'échantillon comportant une structure d'intérêt et une structure de référence imagées lors d'un procédé d'imagerie, objet de la présente invention,
- la figure 4 représente un exemple d'une structure de référence réalisée et utilisée durant un procédé d'imagerie, objet de la présente invention,
- la figure 5 représente une courbe extrapolée exprimant une variation de la tension de focalisation d'un spectromicroscope en fonction de l'énergie cinétique des électrons éjectés lors d'un procédé d'imagerie, objet de la présente invention.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

## EXPOSÉ DÉTAILLÉ DE MODES DE RÉALISATION PARTICULIERS

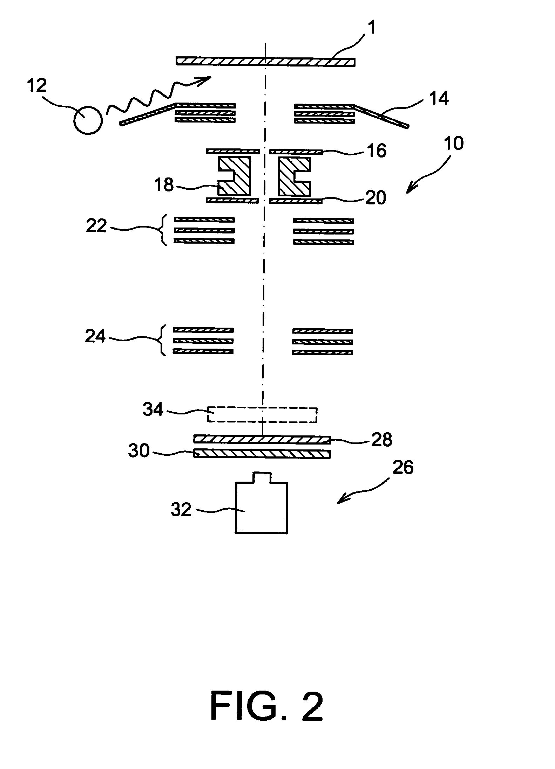

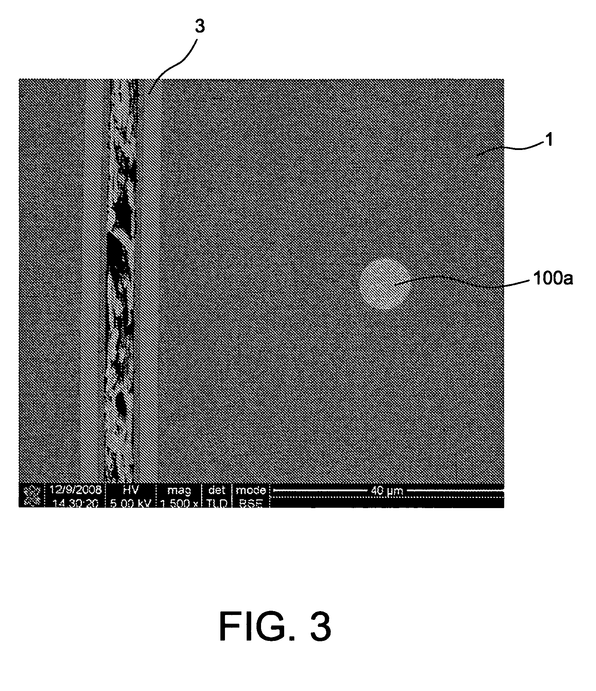

On se réfère tout d'abord à la figure 2 qui représente une colonne optique électronique 10 d'un spectromicroscope, qui est ici une colonne PEEM utilisée pour la mise en oeuvre d'un procédé d'imagerie XPS plein champ d'un échantillon 1, représenté sur la figure 3 dans un champ de vue d'environ 85 µm, sur lequel se trouvent une structure de référence 100a en forme de disque et une structure d'intérêt 3 que l'on cherche à imager. Dans l'exemple décrit ici, la structure d'intérêt 3 est une coupe droite d'un empilement de couches épitaxiées de silicium et de silicium-germanium, et donc ne comporte pas de motif permettant de réaliser une estimation et une correction de l'astigmatisme de la colonne 10 à partir de cette seule structure d'intérêt 3.

Le spectro-microscope comporte également une source d'énergie 12, ici un émetteur de rayons X, permettant d'exciter par effet photoélectrique les atomes des matériaux de l'échantillon 1 recevant son rayonnement. Le système optique de la colonne 10 est composé entièrement d'éléments électrostatiques. La colonne 10 réalise une collecte des photoélectrons éjectés de l'échantillon 1 grâce à un fort champ électrique, par exemple égal à environ 7 kV.mm$^{-1}$, appliqué entre la surface de l'échantillon 1 et une première électrode d'une lentille à immersion, appelée extracteur, qui forme le premier élément de la colonne 10. Cet extracteur est couplé à une lentille de focalisation et forment une partie d'une lentille-objectif 14 de la colonne 10.

La colonne 10 comporte en outre une ouverture de contraste 16 qui permet de limiter l'ouverture angulaire maximum des photoélectrons et au niveau de laquelle se forme le plan focal image (« backfocal plane » en anglais). La colonne 10 comporte ensuite un système de correction de l'astigmatisme et de réglage de la déflection appelé déflecteur/ stigmateur 18, et un diaphragme de sélection d'aire 20 au niveau duquel une image intermédiaire est formée. La colonne 10 comporte ensuite plusieurs lentilles projectives 22 et 24 qui agrandissent l'image intermédiaire pour donner une image finale.

La colonne 10 comporte en outre un détecteur 26 comprenant une galette de microcanaux 28 (ou MCP pour « Micro Channel Plate ») réalisant une amplification de l'image en agissant sur les photoélectrons, et un écran fluorescent 30 convertissant l'image électronique en lumière détectable par une caméra CCD 32. Comme représenté sur l'exemple de la figure 2, le spectro-microscope 10 peut également comporter un filtre à retard d'images 34 disposé entre le détecteur 26 et les lentilles projectives 22 et 24.

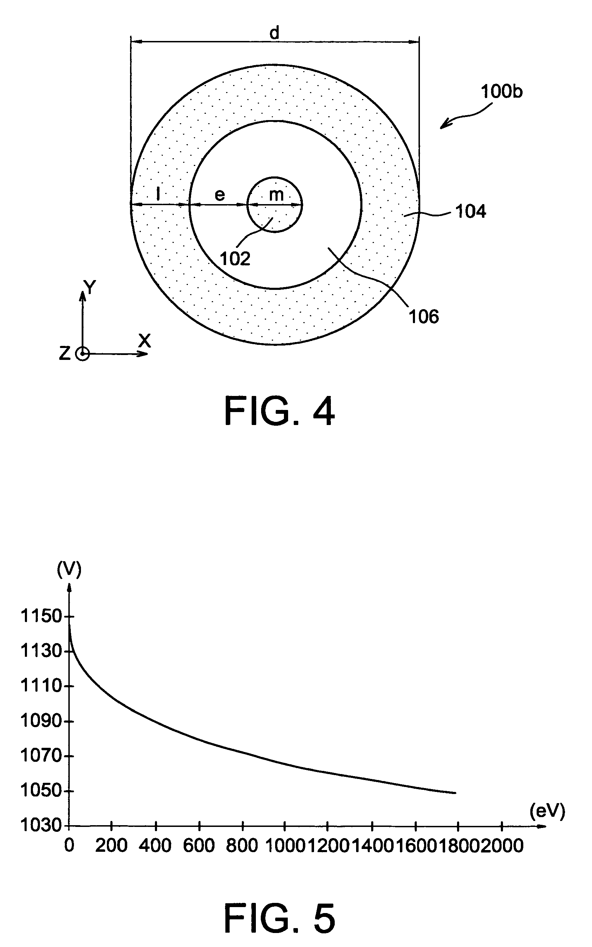

On décrit maintenant un exemple de procédé d'imagerie XPS plein champ de l'échantillon 1 mis en oeuvre avec la colonne 10. Durant ce procédé, l'astigmatisme de la colonne 10 en photoélectrons de niveaux de coeur et à fortiori en électrons secondaires, est corrigé grâce à une structure de référence 100 réalisée sur la surface de l'échantillon 1 à côté de la structure d'intérêt 3, dont un exemple est représenté sur la figure 4.

Sur l'exemple de la figure 4, une structure de référence 100b comporte une première portion de matériau formant un plot 102 dont la forme, dans le plan de la surface de l'échantillon 1, correspondant au plan (X,Y) représenté sur la figure 4, est un disque. La structure de référence 100b comporte en outre une seconde portion de matériau 104 entourant le plot 102 et comportant dans le plan (X,Y) une forme d'anneau. Le plot 102 et l'anneau 104 sont concentriques et distants l'un de l'autre d'une distance « e » non nulle, formant un espace entre le plot 102 et l'anneau 104 au niveau duquel une portion 106 de la surface de l'échantillon 1 n'est pas recouverte par le matériau de la structure de référence 100b, et donc visible par la colonne 10. Cette portion 106 comporte dans le plan (X,Y) une forme d'anneau entourant le plot 102.

La taille générale de la structure de référence 100b, c'est-à-dire les dimensions du contour extérieur de la structure de référence 100b dans le plan de la surface de l'échantillon 1, correspondant ici au diamètre extérieur référencé « d » de la portion 104 en forme d'anneau, est supérieure à environ 1/25$^{ème}$ du champ de vue du spectromicroscope, et par exemple égale à environ 10 µm pour un champ de vue de 90 µm environ. Selon le champ de vue, il est également possible que la taille générale de la structure de référence 100b soit inférieure à environ 1/25$^{ème}$ du champ de vue. Cette structure de référence 100b offre donc une surface assez grande compatible avec une correction d'astigmatisme en photoélectrons de niveaux de coeur ainsi qu'en électrons secondaires pour différents champs de vue.

L'espacement entre les différentes portions de matériau de la structure de référence 100b, ainsi que la largeur (dimension dans le plan de la surface de l'échantillon 1, c'est-à-dire dans le plan (X,Y)) de ces portions, sont choisis en fonction de la résolution spatiale de l'instrument d'observation, à savoir la colonne optique électronique 10. Sur l'exemple de la figure 4, cet espacement correspond à l'écart, référencé « e » sur la figure 4, séparant le plot 102 de la portion en anneau 104. Cet écart « e », ainsi que la largeur de la portion en anneau 104 référencée « l » et le diamètre « m » du plot 102 sont choisis égaux à environ deux fois, ou compris entre environ 1,5 fois et 2,5 fois, la meilleure résolution spatiale pratique obtenue sur des échantillons par le spectro-microscope, suivant l'énergie du rayonnement incident.

Par exemple, dans le cas d'un spectromicroscope de type « NanoESCA », en utilisant une source de rayons X de type AlKα de laboratoire à environ 1486,7 eV, la meilleure résolution spatiale mesurée est égale à environ 500 nm. L'écart « e », la largeur « l » et le diamètre « m » sont donc choisis au moins égaux à environ 1 µm. En utilisant une source de type X-mous comme le rayonnement synchrotron à environ 250 eV, la meilleure résolution spatiale mesurée est égale à environ 100 nm. L'écart « e », la largeur « l » et le diamètre « m » sont choisis dans ce cas au moins égaux à environ 200 nm. Enfin, en utilisant une source de type UV de laboratoire, par exemple à décharge de mercure, égale à environ 4,9 eV, la résolution spatiale est dans ce cas égale à environ 40 nm. L'écart « e », la largeur « l » et le diamètre « m » sont donc choisis au moins égaux à environ 80 nm.

Le matériau de la structure de référence 100b, c'est-à-dire le matériau des portions 102 et 104, est choisi en fonction de celui de l'échantillon 1 sur lequel est réalisée la structure de référence 100b, afin d'avoir un bon contraste avec le matériau de l'échantillon 1. Le matériau de la structure de référence 100b est choisi tel que le contraste C entre l'intensité moyenne $I_a$ du matériau des portions de la structure de référence 100b et l'intensité moyenne $I_b$ du matériau de l'échantillon 1, soit tel que :

$$C = \frac{I_a - I_b}{I_a + I_b} \geq 0{,}2 \ .$$

Un tel contraste peut être obtenu en choisissant de réaliser la structure de référence 100b à partir d'un matériau chimiquement dissemblable du matériau de l'échantillon 1 présentant une différence de travail de sortie par rapport au travail de sortie du matériau de l'échantillon 1. En effet, cette différence de travail de sortie implique que les structures électroniques locales du matériau de la structure de référence 100b, à partir duquel les portions 102 et 104 sont réalisées, et du matériau de l'échantillon 1 sont différentes. La probabilité de photo-excitation et le seuil en énergie à partir desquels des électrons sont émis (seuil de photoémission) sont donc, pour le matériau de la structure de référence 100b, différents de ceux du matériau de l'échantillon 1, ce qui se traduit par une différence d'intensité sur l'image obtenue, correspondant au contraste entre les deux matériaux. Le matériau de la structure de référence 100b peut notamment être choisi tel que celui-ci présente un seuil de photoémission différent de celui de l'échantillon 1, par exemple tel que les travaux de sortie de ces matériaux soient différents d'au moins 0,2 eV. Dans le cas d'un échantillon 1 à base de silicium, le matériau de la structure de référence 100b est par exemple choisi parmi le tungstène, le germanium, le gallium ou encore le titane. De plus, les matériaux de l'échantillon 1 et de la structure de référence 100b peuvent être choisis tels que les valeurs des travaux de sortie de ces matériaux soient inférieures à l'énergie de la source d'excitation lorsqu'il s'agit d'une excitation de basse énergie, par exemple une source UV. Les valeurs du travail de sortie de chaque matériau sont par exemple décrites dans le document « 100 years of work function » de S. Halas, Materials Science-Poland, Vol. 24, N° 4, 2006.

Dans une variante, une différence de contraste entre le matériau de l'échantillon 1 et le matériau de la structure de référence 100b peut également être obtenue en faisant varier la concentration d'un élément commun à ces matériaux. Par exemple, l'échantillon 1 pourrait être à base de GaAs et la structure de référence 100b à base de $Al_xGa_{1-x}As$. Dans une autre variante, une différence de contraste peut également être obtenue en faisant varier le taux de dopage d'un des deux matériaux par rapport à l'autre, par exemple lorsque ces matériaux sont des semi-conducteurs. Il est par exemple possible d'avoir l'échantillon 1 à base de silicium dopé n et une structure de référence 100b à base de silicium dopé p.

Etant donné qu'une correction d'astigmatisme de la colonne 10 en photoélectrons de niveaux de coeur est réalisée dans ce procédé, on cherche également à maximiser l'intensité des images et le contraste entre la surface de l'échantillon 1 et la structure de référence 100b avec les photoélectrons de niveaux de coeur afin d'avoir suffisamment d'électrons ionisés et ainsi obtenir des images en photoélectrons de niveaux de coeur avec une durée d'acquisition relativement faible (quelques minutes au plus).

Dans le cas d'une observation en photoélectrons de niveaux de coeur, l'intensité du contraste est proportionnelle au flux de photons arrivant à la surface de l'échantillon 1. En faisant appel à un rayonnement synchrotron, il est possible de veiller à maximiser ce flux de photons afin de maximiser l'intensité du contraste des images obtenues en photoélectrons de niveaux de coeur.

Le matériau de la structure de référence 100b est ici également choisi en fonction du rayonnement incident avec lequel la surface de l'échantillon 1 est étudiée. En effet, on s'intéresse ici au paramètre de section efficace du matériau, qui correspond à la probabilité de photoexcitation d'un niveau électronique donné, pour un élément donné du matériau et à une énergie de photons donnée. Cette section efficace dépend donc à la fois de l'élément considéré, du niveau électronique considéré et également de l'énergie incidente des photons. Dans le cas présent, le matériau de la structure de référence 100b est choisi tel que les photoélectrons de niveaux de coeur d'un élément constitutif de ce matériau présentent une section efficace égale à au moins 0,1 Mb.

Enfin, le matériau de la structure de référence 100b est choisi en fonction de l'énergie cinétique de ses photoélectrons de niveaux de coeur. On cherche ainsi à imager des niveaux de coeur pour lesquels l'énergie cinétique des photoélectrons de coeur est la plus faible possible, par exemple égale au plus à quelques centaines d'eV ou inférieure à environ 1000 eV. En effet, la transmission T de la colonne 10 varie proportionnellement et inversement à l'énergie cinétique des photoélectrons $E_k$ tel que :

$$T \propto \frac{r_{ap}^{\;2}}{E_k} \; ,$$

avec $r_{ap}$ rayon de l'ouverture de contraste 16 de la colonne 10.

Ainsi, pour des matériaux dont les photoélectrons de niveaux de coeur présentent une bonne section efficace ($\geq 0,1$ Mb), les éléments ayant une énergie de liaison élevée, et donc une énergie cinétique faible (< 200 eV), sont privilégiés, de façon à améliorer la transmission. Le tableau ci-dessous donne des valeurs des sections efficaces et de l'énergie cinétique relatifs à différents matériaux irradiés par un faisceau d'excitation de rayons X à 1486,7 eV. La colonne « raie » correspond aux transitions photoélectriques imagées.

| Matériau | Raie | Sec. Eff. (Mb) | E. cinétique (eV) |
|---|---|---|---|
| Ga | $2p_{3/2}$ | 0,44 | 370 |
| Ge | $2p_{3/2}$ | 0,49 | 270 |
| As | $2p_{3/2}$ | 0,56 | 163 |
| Fe | $2p_{3/2}$ | 0,22 | 777 |
| Co | $2p_{3/2}$ | 0,26 | 708 |
| Ni | $2p_{3/2}$ | 0,30 | 632 |
| Cu | $2p_{3/2}$ | 0,34 | 556 |
| Zn | $2p_{3/2}$ | 0,39 | 466 |
| Mn | $2p_{3/2}$ | 0,19 | 846 |
| Au | $4f_{7/2}$ | 0,25 | 1402 |
| Ag | $3d_{5/2}$ | 0,25 | 1121 |

Enfin, le matériau de la structure de référence 100b peut également être choisi tel que ce matériau ait une énergie de liaison de niveau de coeur proche de celle du matériau de l'échantillon 1 de manière à maximiser la transmission du spectromicroscope.

Enfin, le matériau de la structure de référence 100b peut être choisi parmi les matériaux non électriquement isolants, c'est-à-dire parmi les matériaux conducteurs ou semi-conducteurs, pour éviter les effets de charge, et ne dégazant pas sous ultravide (pression inférieure à environ $10^{-7}$ Pa).

On décrit maintenant un exemple de procédé permettant de choisir le matériau à partir duquel la structure de référence 100b va être réalisée.

Afin de réaliser une correction de l'astigmatisme en électrons secondaires, en fonction de l'énergie du faisceau d'excitation qui est connue, on détermine les matériaux présentant avec celui de l'échantillon 1 une différence de travail de sortie au moins égale à environ 0,2 eV.

Si la correction d'astigmatisme pouvant être réalisée avec une structure de référence réalisée à partir de n'importe lequel de ces matériaux est suffisante, on choisit un de ces matériaux pour réaliser la structure de référence 100b.

Si la correction d'astigmatisme en électrons secondaires ne suffit pas et que l'on souhaite pouvoir corriger l'astigmatisme en photoélectrons de niveaux de coeur, en fonction de l'énergie du faisceau d'excitation qui est connue, on sélectionne, parmi les matériaux précédemment choisis, les matériaux dont les photoélectrons de niveaux de coeur présentent une section efficace supérieure ou égale à environ 0,1 Mb.

On sélectionne alors de préférence, parmi cette nouvelle sélection de matériaux, celui ou ceux présentant un bon contraste avec celui de l'échantillon 1 (supérieur ou égale à 0,2), ainsi qu'une transition photoélectrique d'énergie cinétique faible (par exemple inférieure à environ 200 eV) et proche de celle du matériau de la structure d'intérêt 3.

Une fois que le matériau de la structure de référence 100b est choisi, on réalise alors la structure de référence 100b.

Le matériau de la structure de référence 100b est déposé par des techniques de dépôt localisé, par exemple de type FIB (faisceaux d'ions focalisés), puis usiné pour former les portions 102, 104 concentriques de la structure de référence 100b. L'instrument réalisant le dépôt est lui-même corrigé des défauts d'astigmatisme pour ne pas induire des distorsions sur la structure de référence 100b réalisée.

La structure de référence 100b est déposée près de la structure d'intérêt 3, par exemple à quelques dizaines de microns, ou au plus à environ 500 μm de la structure d'intérêt 3. En effet, étant donné que l'on cherche à corriger les aberrations, c'est-à-dire à aligner du mieux possible les éléments de la colonne optique 10, il est préférable de réduire le plus possible la distance séparant la structure de référence 100b de la structure d'intérêt 3 afin de limiter le décalage pour passer de l'imagerie de la structure de référence 100b à l'imagerie de la structure d'intérêt 3, après avoir réalisé la correction de l'astigmatisme en utilisant la structure de référence 100b, et ainsi limiter les chances de désaligner la colonne optique 10 et d'introduire à nouveau des aberrations. Ainsi, en compensant l'astigmatisme sur la structure de référence 100b, sachant que la structure d'intérêt 3 est proche, on s'assure une minimisation de la correction d'aberrations résiduelles sur la zone de la structure d'intérêt 3 à imager.

On prend également en compte le fait qu'en déposant à la surface de l'échantillon 1 le matériau de la structure de référence 100b, quelle que soit la technique de dépôt localisé utilisée, on peut contaminer les alentours. On veille donc à choisir une distance suffisante pour ne pas endommager la structure d'intérêt 3. Si on ne connaît pas le périmètre des dégâts engendrés par ce dépôt de matériau, on peut tout d'abord déposer le matériau de la structure de référence 100b sur une zone de la surface de l'échantillon 1 qui n'est pas utilisée et éloignée de la structure d'intérêt 3. On peut alors mesurer la zone polluée et prendre en compte cette distance lors du dépôt du matériau de la structure 100b près de la structure d'intérêt 3 sur l'échantillon 1.

Pour réaliser la structure de référence 100b, on réalise de préférence un dépôt d'une épaisseur homogène présentant le moins de topographies possible pour s'affranchir de distorsions éventuelles des images. Ce dépôt peut notamment être réalisé sur une hauteur par exemple comprise entre environ 15 nm et 30 nm. Toutefois, il est possible de réaliser des dépôts plus épais (par exemple compris entre 30 nm et 200 nm, voir même plus) pour former la structure de référence 100b.

Si la surface de la structure d'intérêt 3 à observer est tout de même contaminée ou oxydée, on réalise un nettoyage de celle-ci en effectuant un bombardement ionique sous ultravide dans le spectromicroscope. On veille à ce que le dépôt de matériau de la structure de référence 100b ne soit pas trop fin, c'est-à-dire au moins de quelques nanomètres d'épaisseur, pour que celui-ci puisse résister à un tel bombardement ionique.

Après avoir déposé le matériau de la structure de référence 100b, on réalise un usinage sur une profondeur correspondant à la hauteur de dépôt majorée d'environ 1 ou 2 nm pour être certain d'usiner jusqu'au substrat 1, à travers le matériau de la structure de référence 100b. Pour éviter les effets topographiques, on veille à minimiser l'épaisseur gravée. Le simple dépôt de matériau ne permet généralement pas d'obtenir une structure nette et bien définie, qui par contre peut être obtenue en réalisant un usinage après le dépôt du matériau. Cet usinage permet donc, à partir du dépôt localisé de matériau, de former les différentes portions (102 et 104 sur la figure 4) de la structure de référence 100b.

Etant donné que la structure d'intérêt 3 étudiée ici est formée par un empilement de couches épitaxiées de Si et de SiGe, la structure de référence 100b est par exemple réalisée à base de tungstène. En effet, le travail de sortie du matériau de l'échantillon 1, ici du silicium, qui est de 4,85 eV, est différent de celui du tungstène qui est de 4,55 eV (différence de 0,3 eV). La section efficace des photoélectrons de niveaux de coeur éjectés du tungstène pour une énergie d'excitation de 1486,7 eV (source X de type AlKα) est égale à environ 0,15 Mb.

Etant donné que la source X utilisée ici à 1486,7 eV permet d'obtenir une résolution spatiale d'environ 500 nm, on peut choisir de réaliser la structure de référence 100b sous forme d'anneaux concentriques disposés les uns dans les autres selon une période d'environ 1 μm, le tungstène étant déposé par FIB sur une épaisseur égale à environ 20 nm, puis usiné pour former les portions concentriques de la structure de référence 100b.

Bien que l'exemple de la structure de référence 100b précédemment décrit comporte plusieurs portions de matériau concentriques, il est également possible que la structure de référence ne comporte qu'une seule portion de matériau, du moment que cette unique portion de matériau puisse être utilisée pour corriger l'astigmatisme de la colonne. C'est le cas lorsque les dimensions du contour extérieur de la structure de référence, selon deux axes perpendiculaires l'un par rapport à l'autre et appartenant à un plan parallèle à la surface de l'échantillon, sont sensiblement similaires, comme c'est le cas par exemple pour un disque (comme l'exemple de la structure de référence 100a représentée sur la figure 3), un carré, ou d'autre forme géométrique régulière telle qu'un polygone.

Il est également possible, après la réalisation de la structure de référence 100b, de réaliser une croix de repérage sur la surface de l'échantillon 1, proche de la structure de référence 100b. Une telle croix, de préférence asymétrique, permet de repérer aisément la structure de référence 100b lors de la mise en oeuvre du procédé d'imagerie. En effet, lorsque l'on image la surface de l'échantillon 1, on commence par de grands champs de vue (champs de vue sur plusieurs centaines de micromètres) et il est difficile de repérer la structure de référence 100b. Cette croix permet donc à l'utilisateur de localiser la zone où se trouve la structure de référence 100b et, lorsque la croix est asymétrique, de connaître la direction dans laquelle déplacer la colonne 10 par rapport à l'échantillon 1 pour trouver et imager la structure de référence 100b. Dans l'exemple décrit ici, cette croix est réalisée par dépôt FIB, et la taille des branches de la croix est égale à environ 200 μm. De manière générale, il est également possible de réaliser un motif de repérage d'une forme autre qu'une croix.

Après avoir réalisé la structure de référence 100b, on vérifie que la structure de référence 100b réalisée correspond à la structure désirée (dimensions, topographies, forme, ...). Une telle vérification est par exemple réalisée par une technique de caractérisation de surface complémentaire, par exemple du type KFM (microscopie à force de Kelvin), AFM (microscopie à force atomique) ou MEB (microscopie électronique à balayage).

Si la structure de référence 100b réalisée correspond à celle désirée, on introduit l'échantillon 1 comportant la structure de référence 100b dans le spectromicroscope. A partir de la croix de repérage, on détermine la position de la structure de référence 100b, puis on image la structure de référence 100b par grand champ de vue (par exemple 600 $\mu$m), pour une énergie donnée d'électrons secondaires. Pour chaque champ de vue choisi, on règle la focalisation et la déflection de la colonne 10.

L'astigmatisme, en observation en électrons secondaires, peut alors être corrigé. Pour cela, on fait osciller la tension de focalisation du spectromicroscope. Si la structure de référence 100b apparaît déformée, on règle les tensions des axes Sx et Sy du stigmateur 18. La tension de focalisation du spectromicroscope est ensuite rectifiée pour l'énergie donnée.

Il est alors possible de passer à des champs de vue moyen (par exemple d'environ 100 $\mu$m) et de réaliser une correction d'astigmatisme en électrons secondaires et une correction de la déflection comme précédemment décrit.

On passe alors du mode imagerie en mode spectroscopie.

On réalise un premier spectre à basse résolution pour déterminer les éléments présents à la surface de l'échantillon. Il est ainsi possible de déterminer le degré de contamination de la surface de l'échantillon, et donc de la structure d'intérêt 3, par le dépôt de matériau lors de la réalisation de la structure de référence 100b. Par exemple, si un pic de carbone est détecté, on réalise un bombardement ionique pour décaper la surface de l'échantillon avant de réaliser une imagerie haute résolution des niveaux de coeur de la structure d'intérêt 3. Ce premier spectre permet de réaliser une analyse quantitative élémentaire et de déterminer les raies des éléments d'intérêt de la structure d'intérêt 3, à savoir ceux dont on va chercher à imager les niveaux de coeur.

Pour cela, on réalise tout d'abord un repérage des raies spectrales d'intérêt. On réalise alors des spectres haute résolution de chacune des raies d'intérêt de façon à avoir une mesure affinée de l'énergie cinétique, et donc de l'énergie de liaison des photoélectrons des niveaux de coeur de la structure d'intérêt 3 présente sur l'échantillon 1.

Des imageries sont alors réalisées à différentes énergies cinétiques en faible champ de vue (par exemple inférieur à environ 25 $\mu$m), ce qui implique un réajustement de la tension de focalisation du spectromicroscope. Cette tension dépend non seulement de l'énergie cinétique des électrons, mais aussi de la distance de la structure d'intérêt 3 par rapport à la lentille-objectif 14 de la colonne 10. Après avoir trouvé une tension de focalisation pour une énergie cinétique des électrons secondaires donnée, on choisit une autre énergie cinétique de filtrage des électrons secondaires et on cherche la nouvelle valeur de focalisation.

On réalise ensuite une extrapolation de la courbe obtenue, par exemple par un logiciel adapté, donnant la tension de focalisation en fonction de l'énergie de liaison (et donc de l'énergie cinétique) des photoélectrons, pour avoir une idée de la tension de focalisation qui permettra de faire de l'imagerie en photoélectrons de niveaux de coeur de la structure d'intérêt 3. Comme il faut plus de temps d'intégration pour les niveaux de coeur, connaître d'avance la bonne tension de focalisation permet de réduire le temps d'exécution du procédé d'imagerie. La figure 5 représente un exemple de courbe obtenue par une telle extrapolation, donnant la variation de la tension de focalisation en fonction de l'énergie cinétique des photoélectrons.

Pour chaque raie d'intérêt, c'est-à-dire pour chaque énergie de filtrage, que ce soit pour la structure de référence 100b ou la structure d'intérêt 3, on réalise plusieurs images pour différentes tensions de focalisation sur les photoélectrons des niveaux de coeur pour trouver la meilleure tension de focalisation.

Après avoir déterminé cette meilleure tension de focalisation, on image alors les niveaux de coeur du matériau de la structure de référence 100b et on corrige l'astigmatisme sur cette dernière via les tensions de réglage du stigmateur 18.

L'astigmatisme étant corrigé sur la structure de référence 100b, le champ de vue est déplacé sur la structure d'intérêt 3. Une vérification est réalisée sur la tension de focalisation en contrôlant qu'elle n'a pas changé, et en la corrigeant si nécessaire. Des imageries haute résolution sur les niveaux de coeur de la structure d'intérêt 3 sont ensuite réalisées.

En corrigeant tout d'abord l'astigmatisme sur des images en électrons secondaires, puis sur des images en photoélectrons de niveaux de coeur, on affine progressivement l'annulation d'astigmatisme de la colonne optique électronique du spectromicroscope.

**Revendications**

1. Procédé de correction d'astigmatisme d'une colonne optique électronique (10) d'un spectromicroscope à émission d'électrons, comportant au moins les étapes de :

- réalisation d'une structure de référence (100a, 100b) sur une surface d'un échantillon (1) comportant une structure d'intérêt (3) à imager, les dimensions du contour extérieur de la structure de référence (100a, 100b), selon deux axes perpendiculaires l'un par rapport à l'autre et appartenant à un plan parallèle à la surface de l'échantillon (1), étant sensiblement similaires,
- imagerie de la structure de référence (100a, 100b) par le spectromicroscope en électrons secondaires et en photoélectrons de niveaux de coeur,
- suppression des défauts d'astigmatisme apparaissant lors de l'imagerie de la structure de référence (100a, 100b) en électrons secondaires et en photoélectrons de niveaux de coeur,

un matériau de la structure de référence (100a, 100b) étant choisi tel que, lors d'une imagerie en photoélectrons de niveaux de coeur, le contraste C entre l'intensité moyenne $I_a$ du matériau de la structure de référence (100a, 100b) et l'intensité moyenne $I_b$ du matériau de l'échantillon (1) soit tel qui :

$$C = \frac{I_a - I_b}{I_a + I_b} \geq 0,2 \ .$$

2. Procédé de correction d'astigmatisme selon la revendication 1, dans lequel la structure de référence (100b) comporte une pluralité de portions (102, 104) du matériau de la structure de référence (100b) formant des motifs concentriques de tailles différentes et distants les uns des autres d'une distance non nulle.

3. Procédé de correction d'astigmatisme selon la revendication 2, dans lequel des contours extérieurs des portions (102, 104) de matériau de la structure de référence (100b) sont homothétiques les uns par rapport aux autres et/ou s'étendent à 360° autour du centre de la structure de référence (100b).

4. Procédé de correction d'astigmatisme selon l'une des revendications 2 ou 3, dans lequel les motifs des portions (102, 104) de matériau de la structure de référence (100b) comportent des motifs géométriques disposés les uns dans les autres, ou comportent un motif de grille ou de spirale.

5. Procédé de correction d'astigmatisme selon l'une des revendications 2 à 4, dans lequel les motifs des portions (104) de matériau de la structure de référence (100b) comportent des anneaux.

6. Procédé de correction d'astigmatisme selon l'une des revendications 2 à 5, dans lequel la distance entre les portions (102, 104) de matériau de la structure de référence (100b) et/ou la largeur des portions (102, 104) de matériau de la structure de référence (100b) sont supérieures ou égales à environ deux fois la meilleure résolution spatiale du spectromicroscope lors d'une observation de la structure d'intérêt (3) .

7. Procédé de correction d'astigmatisme selon l'une des revendications précédentes, dans lequel lesdites dimensions du contour extérieur de la structure de référence (100a, 100b) sont au moins égales à environ 1/25ème de la taille du champ de vue du spectromicroscope.

8. Procédé de correction d'astigmatisme selon l'une des revendications précédentes, dans lequel la différence entre le travail de sortie du matériau de la structure de référence (100a, 100b) et le travail de sortie du matériau de l'échantillon (1) est supérieure ou égale à environ 0,2 eV et/ou, lorsque les matériaux de la structure de référence (100a, 100b) et de l'échantillon (1) sont à base d'au moins un même élément, la concentration de cet élément dans le matériau de la structure de référence (100a, 100b) est différente de la concentration de ce composant dans le matériau de l'échantillon (1) et/ou, lorsque les matériaux de la structure de référence (100a, 100b) et de l'échantillon (1) sont de même nature, ces matériaux sont dopés différemment.

9. Procédé de correction d'astigmatisme selon l'une des revendications précédentes, dans lequel la section efficace d'un photoélectron de niveau de coeur d'au moins un élément constitutif du matériau de la structure de référence (100a, 100b) est supérieure ou égale à environ 0,1 Mbarn.

10. Procédé de correction d'astigmatisme selon l'une des revendications précédentes, dans lequel l'énergie cinétique des photoélectrons de niveaux de coeur utilisés pour l'imagerie d'au moins un des éléments constitutifs du matériau de la structure de référence (100a, 100b) est inférieure à environ 1000 eV.

**11.** Procédé de correction d'astigmatisme selon l'une des revendications précédentes, dans lequel la réalisation de la structure de référence (100a, 100b) comporte au moins une étape de dépôt localisé du matériau de la structure de référence (100a, 100b) sur l'échantillon (1) à une distance supérieure à environ 100 μm de la structure d'intérêt (3), et une étape d'usinage du matériau déposé, formant la structure de référence (100a, 100b).

**12.** Procédé de correction d'astigmatisme selon la revendication 11, dans lequel le matériau de la structure de référence (100a, 100b) est déposé sur une épaisseur sensiblement homogène comprise entre environ 15 nm et 200 nm et/ou l'usinage est réalisé sur une profondeur supérieure d'environ 1 nm ou 2 nm à l'épaisseur du matériau déposé.

**13.** Procédé de correction d'astigmatisme selon l'une des revendications précédentes, comportant, avant la mise en oeuvre d'une étape d'imagerie de la structure de référence (100a, 100b) par le spectromicroscope en photoélectrons de niveaux de coeur puis d'une étape de suppression de défauts d'astigmatisme apparaissant lors de l'imagerie de la structure de référence (100a, 100b) en photoélectrons de niveaux de coeur, une étape d'imagerie de la structure de référence (100a, 100b) par le spectromicroscope en électrons secondaires, puis une étape de suppression de défauts d'astigmatisme apparaissant lors de l'imagerie de la structure de référence (100a, 100b) en électrons secondaires.

**14.** Procédé de correction d'astigmatisme selon l'une des revendications précédentes, dans lequel une suppression de défauts d'astigmatisme apparaissant lors de l'imagerie de la structure de référence (100a, 100b) en électrons secondaires ou en photoélectrons de niveaux de coeur est réalisée par un ajustement de tensions de réglages des axes d'un stigmateur (18) de la colonne (10) puis par un ajustement d'une tension de focalisation du spectromicroscope.

**15.** Procédé d'imagerie par spectromicroscopie à émission d'électrons, comportant la mise en oeuvre d'un procédé de correction d'astigmatisme selon l'une des revendications précédentes, et une ou plusieurs étapes d'imagerie de la structure d'intérêt (3) en électrons secondaires et/ou en photoélectrons de niveaux de coeur.

**Patentansprüche**

**1.** Verfahren zur Astigmatismus-Korrektur einer elektronenoptischen Säule (10) von einem Spektromikroskop mit Elektronen-Emission, umfassend wenigstens die Schritte:

- Herstellung einer Referenzstruktur (100a, 100b) auf einer Oberfläche einer Probe (1), welche eine darzustellende, interessierende Struktur (3) umfasst, wobei die Abmessungen der äußeren Kontur der Referenz-Struktur (100a, 100b) entlang zweier Achsen, die zueinander senkrecht sind und zu einer zu der Oberfläche der Probe (1) parallelen Fläche gehören, im Wesentlichen ähnlich sind,
- Darstellung der Referenz-Struktur (100a, 100b) durch das Spektromikroskop mit Sekundärelektronen und Rumpfniveau-Photoelektronen,
- Unterdrückung von Astigmatismus-Fehlern, die bei der Darstellung der Referenz-Struktur (100a, 100b) mit Sekundärelektronen und Rumpfniveau-Photoelektronen erscheinen,
wobei ein Material der Referenz-Struktur (100a, 100b) so ausgewählt ist, dass bei einer Darstellung mit Rumpfniveau-Photoelektronen der Kontrast C zwischen der mittleren Intensität $I_a$ des Materials der Referenz-Struktur (100a, 100b) und der mittleren Intensität $I_b$ des Materials der Probe (1) so ist, dass

$$C = \frac{I_a - I_b}{I_a + I_b} \geq 0.2$$

gilt.

**2.** Verfahren zur Astigmatismus-Korrektur nach Anspruch 1, wobei die Referenz-Struktur (100b) eine Mehrzahl von Abschnitten (102, 104) aus dem Material der Referenz-Struktur (100b) umfasst, welche konzentrische Motive bilden, die unterschiedlich groß und voneinander um einen von Null verschiedenen Abstand entfernt sind.

**3.** Verfahren zur Astigmatismus-Korrektur nach Anspruch 2, wobei die äußeren Konturen der Abschnitte (102, 104) aus dem Material der Referenz-Struktur (100b) zueinander homothetisch sind oder/und sich um 360° um das Zentrum der Referenz-Struktur (100b) herum erstrecken.

4. Verfahren zur Astigmatismus-Korrektur nach einem der Ansprüche 2 oder 3, wobei die Motive der Abschnitte (102, 104) aus dem Material der Referenz-Struktur (100b) geometrische Motive umfassen, die ineinander angeordnet sind, oder ein Gitter- oder Spiralen-Motiv umfassen.

5. Verfahren zur Astigmatismus-Korrektur nach einem der Ansprüche 2 bis 4, wobei die Motive der Abschnitte (104) aus dem Material der Referenz-Struktur (100b) Ringe umfassen.

6. Verfahren zur Astigmatismus-Korrektur nach einem der Ansprüche 2 bis 5, wobei der Abstand zwischen den Abschnitten (102, 104) aus dem Material der Referenz-Struktur (100b) oder/und die Breite der Abschnitte (102, 104) aus dem Material der Referenz-Struktur (100b) größer oder gleich ungefähr zwei Mal der besten räumlichen Auflösung des Spektromikroskops bei einer Betrachtung der interessierenden Struktur (3) sind.

7. Verfahren zur Astigmatismus-Korrektur nach einem der vorhergehenden Ansprüche, wobei die Abmessungen der äußeren Kontur der Referenz-Struktur (100a, 100b) wenigstens gleich ungefähr 1/25 der Größe des Blickfeldes von dem Spektromikroskop sind.

8. Verfahren zur Astigmatismus-Korrektur nach einem der vorhergehenden Ansprüche, wobei die Differenz zwischen der Austrittsarbeit des Materials der Referenz-Struktur (100a, 100b) und der Austrittsarbeit des Materials der Probe (1) größer oder gleich etwa 0,2 eV ist, oder/und dann, wenn die Materialien der Referenz-Struktur (100a, 100b) und der Probe (1) auf wenigstens einem gleichen Element basieren, die Konzentration von diesem Element in dem Material der Referenz-Struktur (100a, 100b) verschieden von der Konzentration dieser Komponente in dem Material der Probe (1) ist, oder/und dann, wenn die Materialien der Referenz-Struktur (100a, 100b) und der Probe (1) gleichartig sind, diese Materialien unterschiedlich dotiert sind.

9. Verfahren zur Astigmatismus-Korrektur nach einem der vorhergehenden Ansprüche, wobei der Wirkungsquerschnitt von einem Rumpfniveau-Photoelektron von wenigstens einem Element, das in dem Material der Referenz-Struktur (100a, 100b) enthalten ist, größer oder gleich ungefähr 0,1 Mbarn ist.

10. Verfahren zur Astigmatismus-Korrektur nach einem der vorhergehenden Ansprüche, wobei die kinetische Energie der für die Darstellung verwendeten Rumpfniveau-Photoelektronen von wenigstens einem der Elemente, die in dem Material der Referenz-Struktur (100a, 100b) enthalten sind, kleiner als ungefähr 1000 eV ist.

11. Verfahren zur Astigmatismus-Korrektur nach einem der vorhergehenden Ansprüche, wobei die Herstellung der Referenz-Struktur (100a, 100b) wenigstens einen Schritt umfasst, lokalisiert Material der Referenz-Struktur (100a, 100b) auf die Probe (1) in einem Abstand von der interessierenden Struktur (3) aufzubringen, der größer ist als ungefähr 100 $\mu$m, und einen Schritt umfasst, das aufgebrachte Material zu bearbeiten, wodurch die Referenz-Struktur (100a, 100b) gebildet wird.

12. Verfahren zur Astigmatismus-Korrektur nach Anspruch 11, wobei das Material der Referenz-Struktur (100a, 100b) mit einer im Wesentlichen homogenen Dicke von zwischen ungefähr 15 nm und 200 nm aufgebracht wird, oder/und die Bearbeitung über eine Tiefe durchgeführt wird, die um etwa 1 nm oder 2 nm größer ist als die Dicke des aufgebrachten Materials.

13. Verfahren zur Astigmatismus-Korrektur nach einem der vorhergehenden Ansprüche, umfassend, vor der Umsetzung eines Schritts der Darstellung der Referenz-Struktur (100a, 100b) durch das Spektromikroskop mit Rumpfniveau-Photoelektronen und dann eines Schritts der Unterdrückung von Astigmatismus-Fehlern, die bei der Darstellung der Referenz-Struktur (100a, 100b) mit Rumpfniveau-Photoelektronen erscheinen, einen Schritt der Darstellung der Referenz-Struktur (100a, 100b) durch das Spektromikroskop mit Sekundärelektronen und dann einen Schritt der Unterdrückung von Astigmatismus-Fehlern, die bei der Darstellung der Referenz-Struktur (100a, 100b) mit Sekundärelektronen erscheinen.

14. Verfahren zur Astigmatismus-Korrektur nach einem der vorhergehenden Ansprüche, wobei eine Unterdrückung von Astigmatismus-Fehlern, die bei der Darstellung der Referenz-Struktur (100a, 100b) mit Sekundärelektronen oder mit Rumpfniveau-Photoelektronen erscheinen, umgesetzt wird durch eine Einstellung von Regelspannungen der Achsen von einem Stigmator (18) der Säule (10), und dann durch eine Einstellung einer Spannung zur Fokussierung des Spektromikroskops.

**15.** Bildgebungsverfahren durch Spektromikroskopie mit Elektronen-Emission, umfassend die Umsetzung eines Verfahrens zur Astigmatismus-Korrektur nach einem der vorhergehenden Ansprüche und einen oder mehrere Schritte zur Darstellung der interessierenden Struktur (3) mit Sekundärelektronen oder/und mit Rumpfniveau-Photoelektronen.

**Claims**

**1.** Method for correcting astigmatism of an electronic optical column (10) of an electron emission spectromicroscope, comprising at least the steps of:

- forming a reference structure (100a, 100b) on a surface of a sample (1) comprising a structure of interest (3) to be imaged, the dimensions of the exterior contour of the reference structure (100a, 100b), along two axes perpendicular to each other and lying in a plane parallel to the surface of the sample (1), being substantially similar,
- imaging the reference structure (100a, 100b) by the spectromicroscope with secondary electrons and with core level photoelectrons,
- eliminating astigmatism defects appearing during the imaging of the reference structure (100a, 100b) with secondary electrons and with core level photoelectrons,
a material of the reference structure (100a, 100b) being chosen such that, during core level photoelectron imaging, the contrast C between the average intensity $I_a$ of the material of the reference structure (100a, 100b) and the average intensity $I_b$ of the material of the sample (1) is such that:

$$C = \frac{I_a - I_b}{I_a + I_b} \geq 0.2 \ .$$

**2.** Method for correcting astigmatism according to claim 1, wherein the reference structure (100b) comprises a plurality of portions (102, 104) of the material of the reference structure (100b) forming concentric patterns of different sizes and separated from each other by a non-zero distance.

**3.** Method for correcting astigmatism according to claim 2, wherein exterior contours of portions (102, 104) of material of the reference structure (100b) are homothetic to each other and/or extend 360° around the centre of the reference structure (100b).

**4.** Method for correcting astigmatism according to one of claims 2 or 3, wherein the patterns of the portions (102, 104) of material of the reference structure (100b) comprise geometric patterns arranged within each other, or comprising a grid or spiral pattern.

**5.** Method for correcting astigmatism according to one of claims 2 to 4, wherein tne patterns of the portions (104) of material of the reference structure (100b) comprise rings.

**6.** Method for correcting astigmatism according to one of claims 2 to 5, wherein the distance between the portions (102, 104) of material of the reference structure (100b) and/or the with of the portions (102, 104) of material of the reference structure (100b) are greater than or equal to around twice the best spatial resolution of the spectromicroscope during an observation of the structure of interest (3).

**7.** Method for correcting astigmatism according to one of the preceding claims, wherein said dimensions of the exterior contour of the reference structure (100a, 100b) are at least equal to around 1/25th of the size of the field of view of the spectromicroscope.

**8.** Method for correcting astigmatism according to one of the preceding claims, wherein the difference between the work function of the material of the reference structure (100a, 100b) and the work function of the material of the sample (1) is greater than or equal to around 0.2 eV and/or, when the materials of the reference structure (100a, 100b) and the sample (1) are based on at least one same element, the concentration of said element in the material of the reference structure (100a, 100b) is different from the concentration of this component in the material of the sample (1) and/or, when the materials of the reference structure (100a, 100b) and the sample (1) are of the same nature, said materials are doped differently.

9. Method for correcting astigmatism according to one of the preceding claims, wherein the cross section of a core level photoelectron of at least one constituent element of the material of the reference structure (100a, 100b) is greater than or equal to around 0.1 Mbarn.

10. Method for correcting astigmatism according to one of the preceding claims, wherein the kinetic energy of the core level photoelectrons used for imaging at least one of the constituent elements of the material of the reference structure (100a, 100b) is less than around 1000 eV.

11. Method for correcting astigmatism according to one of the preceding claims, wherein the formation of the reference structure (100a, 100b) comprises at least one step of localised deposition of the material of the reference structure (100a, 100b) on the sample (1) at a distance greater than around 100 $\mu$m from the structure of interest (3), and a step of machining the deposited material, forming the reference structure (100a, 100b).

12. Method for correcting astigmatism according to claim 11, wherein the material of the reference structure (100a, 100b) is deposited over a substantially uniform thickness between around 15 nm and 200 nm and/or the machining is carried out over a depth greater than around 1 nm or 2 nm in the thickness of the deposited material.

13. Method for correcting astigmatism according to one of the preceding claims, comprising, before the implementation of a step of imaging the reference structure (100a, 100b) by the spectromicroscope with core level photoelectrons then a step of eliminating astigmatism defects appearing during the core level photoelectron imaging of the reference structure (100a, 100b), a step of imaging the reference structure (100a, 100b) by the spectromicroscope with secondary electrons, then a step of eliminating astigmatism defects appearing during the secondary electron imaging of the reference structure (100a, 100b).

14. Method for correcting astigmatism according to one of the preceding claims, wherein an elimination of astigmatism defects appearing during the imaging of the reference structure (100a, 100b) with secondary electrons or with core level photoelectrons is carried out by an adjustment of control voltages of the axes of a stigmator (18) of the column (10) then by an adjustment of a focusing voltage of the spectromicroscope.

15. Method of electron emission spectromicroscopy imaging, comprising the implementation of a method for correcting astigmatism according to one of the preceding claims, and one or more steps of imaging the structure of interest (3) with secondary electrons and/or with core level photoelectrons.

FIG. 1A

FIG. 1B

FIG. 2

FIG. 3

FIG. 4

FIG. 5

**RÉFÉRENCES CITÉES DANS LA DESCRIPTION**

**Documents brevets cités dans la description**

- US 7126120 B2

- JP 2004265652 B

**Littérature non-brevet citée dans la description**

- **S. HALAS.** 100 years of work function. *Materials Science-Poland,* 2006, vol. 24 (4